# EUROPEAN PATENT APPLICATION

(11) **EP 1 536 532 A1**
(43) Date of publication of application: **01.06.2005**
(21) Application number: 04027749.3
(22) Date of filing: 23.11.2004
(51) Int. Cl.: H01S 5/40, H01S 5/02

(54) **Semiconductor laser device**

(30) Priority: 25.11.2003 JP 2003394084
(71) Applicant: FANUC LTD, Minamitsuru-gun, Yamanashi 401-0597 (JP)
(72) Inventor: Nishikawa, Yuji Room 14-408, Fanuc Manshonharimomi, Minamitsuru-gun Yamanashi 401-0511 (JP); Takigawa, Hiroshi, Isehara-shi Kanagawa 259-1117 (JP); Miyata, Ryusuke Room 12-403, Fanuc Manshonharimomi, Minamitsuru-gun Yamanashi 401-0511 (JP)
(74) Representative: Schmidt, Steffen J., Dipl.-Ing.

(57) **Abstract**

A semiconductor laser device, including an LD array member (22) having a monolithic linear-array configuration and provided with a plurality of emitters (26), respectively emitting a laser beam, in a parallel arrangement in a single semiconductor crystal (28,30). The LD array member includes a main area (36) in which the emitters are disposed in the parallel arrangement, a first inactive area (32) formed outside of the main area, and a second inactive area (34) formed between the emitters disposed side-by-side in the main area. The first inactive area has a dimension larger than the second inactive area, as seen in a direction transverse to the plurality of emitters. The LD array member includes a first facet (44), in which emitting ends of the emitters are disposed, and a second facet (46) opposite to the first facet; at least one of the first facet and the second facet being covered by a coating material (48). The LD array member also includes a pair of lateral faces (50) respectively intersecting each of the first and second facets; at least one of the lateral faces being covered at least partially by a coating material (48).

## Description

### BACKGROUND OF THE INVENTION

### 1. Field of the Invention

The present invention relates to a semiconductor laser device.

### 2. Description of the Related Art

Recently, a semiconductor laser device, i.e., a laser diode (LD), has been used because an improvement in the efficiency of a laser oscillator for machining is required. For example, in an application requiring a high power, such as a welding or a fusing, the semiconductor laser device has been used as an excitation light source for a solid-state laser, such as an Nd:YAG laser, or a direct light source for machining. The semiconductor laser device has various characteristics such that the electricity/light conversion efficiency thereof is as high as approximately 50%, which is higher than any other type of laser, that the wave length thereof is relatively freely selectable in a range from a visible area to the near-infrared area, which makes it easier to construct an optical system by, e.g., allowing a transmission through an optical fiber, or that the dimension thereof is compact and the life thereof is relatively long.

The semiconductor laser device used for machining requires a high power and, thus, is generally provided with an LD array member having a linear array configuration in which a plurality of emitters, respectively emitting a laser beam, are monolithically integrated and disposed in a one-dimensional or parallel arrangement. Also, in order to increase an output of each emitter, the emitter is generally configured to have a so-called single stripe structure of which a current injection area is large in width (i.e., a dimension in a transverse direction) or a so-called stripe aggregate structure in which a plurality of relatively thinner emitters (i.e., stripe elements) are disposed close to each other in a width direction (i.e., a transverse direction).

In this regard, as an amount of Joule heat increases as the laser power becomes higher in the linear LD array member, the semiconductor device is used in the configuration in which the linear LD array member is mounted to a cooling member, such as an active cooling unit through which coolant flows or a heat sink having excellent radiation properties. Also, the semiconductor laser device using the linear LD array member is particularly required to have a high operational reliability and a low production cost, because a large number of LD array members may be incorporated in an assembled state into a single laser oscillator so as to obtain a significantly higher power and in the kilowatt order.

The LD array member having the linear array configuration, in which the plural emitters are integrated together, is manufactured by cutting, to divide, a semiconductor wafer in which the emitters are disposed throughout in a parallel arrangement, in a cleaving manner into a plurality of LD array members, each having a predetermined width (i.e., a dimension in a direction transverse to the emitters). In this manufacturing process, a scribe line is generally formed for facilitating a cleavage at a predetermined position on the semiconductor wafer. Then, in each of the divided LD array members, a portion on which the scribe line is formed is cut out or removed by a further cleavage, so as to prevent a short-circuit due to a leakage current generating in a portion of p-n junction broken by the formation of the scribe line.

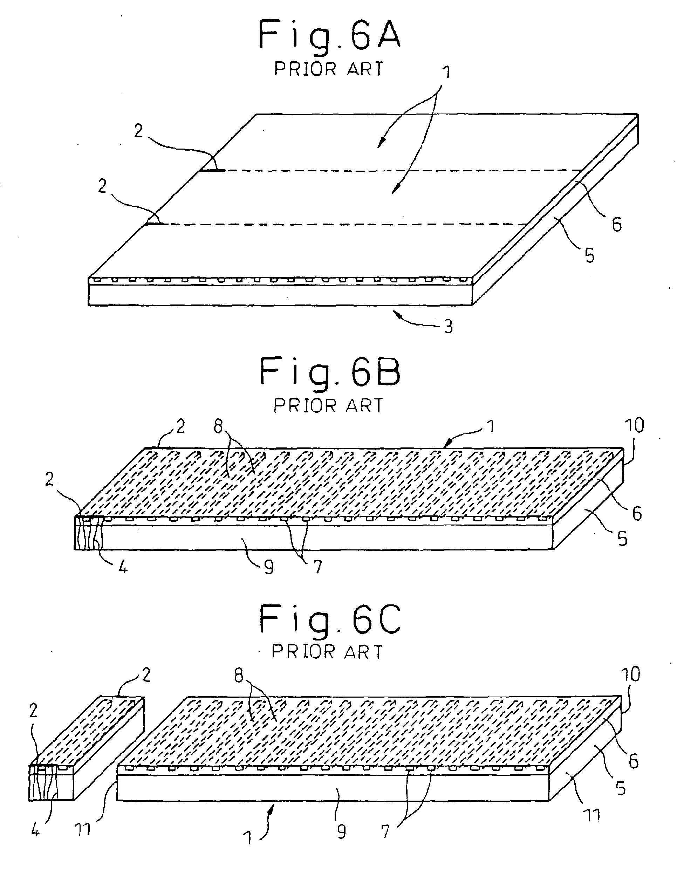

The conventional process for manufacturing an LD array member, wherein the portion on which the scribe line is formed is removed by cleavage, will be described with reference to Figs. 6A to 6C. Fig. 6A shows a wafer 3, on which scribe lines 2 are formed for dividing the wafer 3 into a plurality of LD array members 1; Fig. 6B shows one divided LD array member 1 cut out by the cleavage; and Fig. 6C shows a state in which a portion 4, wherein a normal cleavage plane has not been obtained due to a stress caused by the formation of the scribe line 2, is further cut out from the LD array member 1 in the cleaving manner.

As illustrated, in order to precisely divide the LD array members 1 each having a predetermined width (i.e., a dimension in a direction transverse to the emitters) from the wafer 3 in the cleaving manner, relatively long scribe lines 2 are previously formed on the wafer in a width direction of the LD array member 1 (i.e., a direction transverse to the emitters). In a portion 4 on which the scribe line 2 is formed, a p-n junction in a laser-structure crystal 6, made on a substrate crystal 5 through, e.g., an epitaxial growth, is damaged, and the emitters 7 are also damaged, which causes an increase in a leakage current or a short-circuit. Also, a cleavage plane of the portion 4, on which the scribe line 2 is formed, is subjected to a stress in the crystal thereof, so that it is difficult to obtain a flat cleavage plane in both of the substrate crystal 5 and the laser structure crystal 6, which results in an incomplete laser resonance structure.

Therefore, the portion 4 of the LD array member 1 is cut out or removed in the cleaving manner along a second scribe line formed in a longitudinal direction of the emitter with a shorter length than the scribe line 2. Thereby, the LD array member 1 is obtained, which has the laser structure crystal 6 including the emitters 7 and inactive areas 8, both free from damage. Then, a coating material is applied or vapor-deposited to the LD array member 1 on a first facet 9 at a laser emitting side, formed by a cleavage, and a second facet 10 opposite to the first facet 9, in order to provide a surface protection and a reflectance control. Thereafter, the LD array member 1 is mounted to a desired cooling member (not shown). During this procedure, if a direct handling operation, such as a pick-up, is carried out in, e.g., a mounting operation of the LD array member 1 onto a coating jig, the LD array member 1 may be subjected to a stress to cause a deficiency in the crystal. Accordingly, it is desirable that the LD array member 1 is handled by gripping the portion 4, prior to removing the portion 4, and that the portion 4 is cut out or removed after the coating process and the resultant LD array member 1 is mounted to the cooling member.

As described above, when the portion 4 is cut out after the coating process, it is possible to prevent leakage current due to the damaged p-n junction from increasing. However, a pair of lateral surfaces 11 of the LD array member 1, intersecting with both of the first facet 9 and the second facet 10, are exposed in the form of cleavage planes, so that in the case where soldering is used for mounting the LD array member 1 to the cooling member, a solder may be adhered to the exposed lateral surfaces 11, which may cause a short-circuit. Also, the step for cutting out the portion 4 from the LD array member 1 increases the number of producing steps and a production cost.

### SUMMARY OF THE INVENTION

It is an object of the present invention to provide a semiconductor laser device including a high-performance and low-cost type LD array member having high structural reliability, in which it is possible to prevent an increase in leakage current and a deterioration in characteristics, without cutting out a portion on which a scribe line is formed for a cleavage, even when the scribe line is formed on a wafer during a manufacturing process of the LD array member.

To accomplish the above object, the present invention provides a semiconductor laser device, comprising an LD array member having a monolithic linear-array configuration and provided with a plurality of emitters, respectively emitting a laser beam, in a parallel arrangement in a single semiconductor crystal; the LD array member including a main area in which the emitters are disposed in the parallel arrangement, a first inactive area formed outside of the main area, and a second inactive area formed between the emitters disposed side-by-side in the main area; the first inactive area having a dimension larger than the second inactive area, as seen in a direction transverse to the plurality of emitters.

In the above semiconductor laser device, the LD array member may include three or more emitters disposed in the parallel arrangement at a regular pitch.

Also, the LD array member may include a plurality of second inactive areas having dimensions identical to each other.

Alternatively, the LD array member may include three or more emitters, a pair of first inactive areas disposed at opposite outsides of the main area and a plurality of second inactive areas; each of the pair of first inactive areas having a dimension larger than each of the plurality of second inactive areas, as seen in a direction transverse to the three or more emitters.

Also, the LD array member may include a first facet, in which emitting ends of the emitters are disposed, and a second facet opposite to the first facet; at least one of the first facet and the second facet being covered by a coating material.

In this arrangement, the LD array member may include a pair of lateral faces respectively intersecting each of the first and second facets; at least one of the lateral faces being covered at least partially by a coating material.

The above semiconductor laser device may further comprise a cooling member to which the LD array member is mounted.

In this arrangement, the semiconductor laser device may further comprise a spacer interposed between the LD array member and the cooling member.

Each of the plurality of emitters may be a single stripe element having a dimension of at least 10 µm in a transverse direction.

Alternatively, each of the plurality of emitters may be a stripe aggregate including a plurality of stripe elements, each having a dimension of at most 5 µm in a transverse direction, disposed in a parallel arrangement at a regular pitch of at most 5 µm.

The LD array member may include an identification mark formed on a surface portion corresponding to the first inactive area.

### BRIEF DESCRIPTION OF THE DRAWINGS

The above and other objects, features and advantages of the present invention will become more apparent from the following description of preferred embodiments in connection with the accompanying drawings, wherein:
Fig. 1A is a perspective view schematically or typically showing an LD array member of a semiconductor laser device, according to a first embodiment of the present invention;
Fig. 1B is a perspective view schematically or typically showing the semiconductor laser device of the first embodiment, in which the LD array member of Fig. 1A is mounted to a cooling member;
Fig. 2 is a perspective view schematically or typically showing a step for applying a coating material to opposite lateral surfaces of the LD array member of Fig. 1A;
Fig. 3A is a perspective view schematically or typically showing a semiconductor laser device, according to a second embodiment of the present invention;
Fig. 3B is a perspective view showing a modification of the semiconductor laser device of the second embodiment;
Fig. 3C is a perspective view showing another modification of the semiconductor laser device of the second embodiment;
Fig. 4A is a plan view showing the LD array member, in the first and second embodiments;
Fig. 4B is a plan view showing a modification of the LD array member;
Fig. 5 is a plan view showing an LD array member of a semiconductor laser device, according to a third embodiment of the present invention;
Fig. 6A is a perspective view schematically or typically showing one step of a prior art process for manufacturing an LD array member;
Fig. 6B is a perspective view schematically or typically showing another step of the manufacturing process of Fig. 6A; and
Fig. 6C is a perspective view schematically or typically showing a further step of the manufacturing process of Fig. 6A.

### DETAILED DESCRIPTION

The present invention solves the above-described problems in a semiconductor laser device including an LD array member having a monolithic linear-array configuration, the LD array member being provided with a plurality of emitters, respectively emitting a laser beam, in a parallel side-by-side arrangement in a single semiconductor crystal, by forming at least one of first inactive areas located at opposite end regions of the LD array member in such a manner as to be wider than a second inactive area provided between the emitters arranged side-by-side.

Generally, in the conventional LD array member, a pitch of a plurality of emitters is in a range from about 100 to 500 µm. The number of emitters increases as a width (i.e., a dimension in a transverse direction) of the respective emitter becomes thinner, so that a width of the second inactive area between the emitters is generally designed as narrow as 50 to 350 µm. On the other hand, the first inactive areas at opposite ends of the LD array member are resultingly obtained by dividing a predetermined second inactive area between the adjacent two emitters into two parts, in a step for dividing a wafer into a plurality of LD array members and, consequently, each of the first inactive areas generally has a width approximately half a width of the second inactive area. If the scribe line is formed solely in the first inactive area having such a narrow width, so as to form the divided LD array member having a generally 10 mm width (i.e., a dimension in a direction transverse to the emitters) by cutting the wafer in the cleaving manner, there might be a case wherein the cleavage does not occur accurately along the scribe line, whereby it is difficult to precisely form the divided LD array member having a predetermined shape. As a result, the yield of the LD array member lowers and the production cost thereof rises.

Contrary to this, according to the present invention, a first inactive area wider than a second inactive area between the emitters is formed at an outer peripheral region defined in a width direction of the LD array member, so as to permit a scribe line to be formed in the first inactive area, the scribe line having a length necessary for precisely forming, with a high yield, the divided LD array member by cutting an wafer in the cleaving manner. As a result, the present invention can solve the problem in that the p-n junction in the emitter is damaged due to the scribe line so as to increase the leakage current.

The present invention may also be configured in such a manner that a pair of first inactive areas are provided at opposite end regions defined in the width direction of the LD array member, that each of the first inactive areas is formed larger in width than the second inactive area, and that the scribe lines are formed in the respective first inactive areas to be aligned with each other on a common line. In this arrangement, during the cleaving or cutting step for forming the LD array members, the cleavage is further precisely formed to extend along the extension line of the scribe lines (i.e., along a straight line connecting the scribe lines with each other).

According to the present invention, the LD array member is mounted to a cooling member without separating the first inactive area used for forming the scribe line from the LD array member, so that it is possible to eliminate a step for cutting out a portion on which the scribe line is formed, which is generally performed in a conventional process, and to reduce the number of manufacturing steps. Also, in a handling operation exclusively for the LD array member, it is possible to handle the LD array member by, e.g., absorbing the relatively large first inactive area with a vacuum pincette or others, so that it is possible to prevent a crystal deficiency from occurring in the emitter or the circumference thereof due to a stress.

Further, in an arrangement wherein the LD array member is mounted to a cooling member, such as a heat sink or a cooling unit, through a spacer (a die spacer), it is possible to reduce the stress applied to the LD array member due to the difference in coefficient of thermal expansion between the LD array member and the cooling member. In addition, if the LD array member is mounted to the cooling member in such a manner that the end of the LD array member, as seen in the width direction, extends outward from a soldering surface of the die spacer (or from the die spacer itself), it is surely prevented that solder is adhered to the lateral outer surface of the LD array member to cause a short-circuit of the p-n junction in the laser structure crystal.

In order to realize the LD array member with high reliability and performance, corresponding to the object of the present invention, it is preferred that the individual emitter has a single stripe structure having at least 10 µm width, or a stripe aggregate structure including a plurality of stripe elements each having at most 5 µm width and disposed in a parallel arrangement at a pitch of 5 µm or less. Thereby, even if the laser output from a single emitter is increased, it is possible to maintain the high reliability of performance. Further, in the present invention, the dimension of the first inactive area for forming the scribe line necessary for dividing the wafer into the LD array member can be selected irrespective of a width or a pitch of the emitter, so that it is possible to optimally design the emitter without any constraints, such as a consideration for damage due to a scribing.

The embodiments of the present invention are described below in detail, with reference to the accompanying drawings. In the drawings, the same or similar components are denoted by common reference numerals.

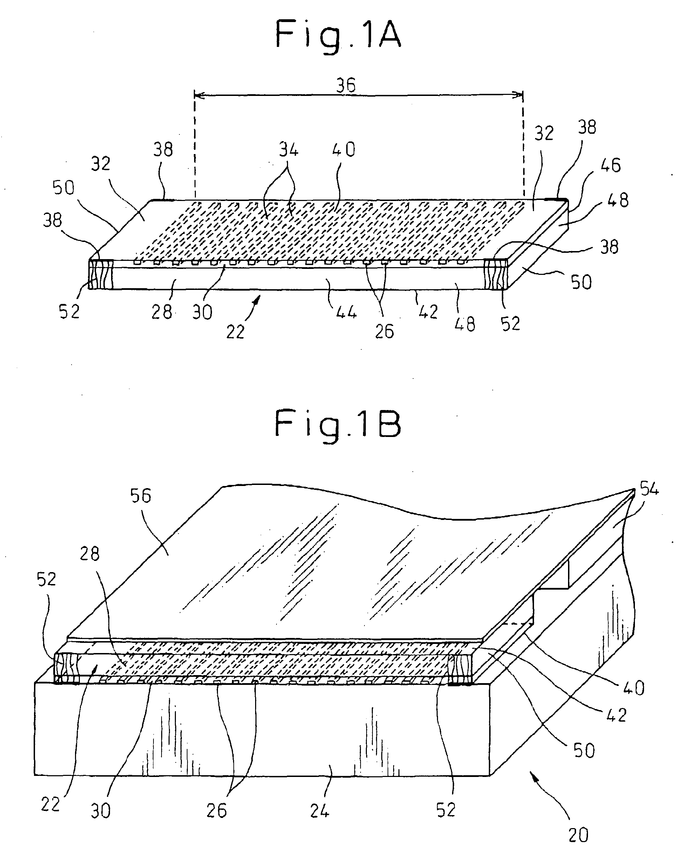

Referring to the drawings, Figs. 1A and 1B are illustrations for explaining a semiconductor laser device 20, according to a first embodiment of the present invention, wherein Fig. 1A typically or schematically shows an LD array member 22 formed by a cutting step in a cleaving manner, in a state before it is mounted to a cooling member such as a heat sink or a cooling unit, and Fig. 1B typically or schematically shows the LD array member 22 in a state after being mounted to the cooling member 24. As shown in Fig. 1A, the LD array member 22 has a monolithic linear-array configuration in which a plurality of emitters, respectively emitting a laser beam, are provided in a parallel side-by-side arrangement in a single semiconductor crystal. The semiconductor crystal forming the LD array member 22 includes a substrate crystal 28 and a laser structure crystal 30 formed, e.g., by an epitaxial growth on the substrate crystal 28. The laser structure crystal 30 has a p-n junction designed to confining a light and a carrier therein, and is provided, in addition to the emitters 26 emitting the laser beam by passing an electric current thereto, with inactive areas 32, 34 allowing no electric current to flow therein.

More specifically, the LD array member 22 includes a main area 36 in which the emitters 26 are disposed in the parallel arrangement, a first inactive area 32 formed outside of the main area 36, and a second inactive area 34 formed between the emitters 26 disposed side-by-side in the main area 36. The first inactive area 32 has a dimension larger than the second inactive area 34, as seen in a width direction of the LD array member 22 (i.e., a direction transverse to the plural stripe-shaped emitters 26).

According to the above structure, it is possible to form a scribe line 38 on a wafer (not shown), which is used for dividing the wafer to provide the LD array member 22 having a predetermined shape by a cutting step in a cleaving manner, so as to be included within the first inactive area 32, while ensuring a length of the scribe line 38 necessary for a precise cleavage. As a result, it is possible to avoid damage on the emitter 26 due to the formation of the scribe line 38, and thus it is possible to prevent an increase in leakage current and a deterioration in characteristics. Also, in a handling operation for the LD array member 22, it is possible to pick up the first inactive area 32 by a vacuum pincette or others, so that it is possible to prevent a crystal deficiency from occurring in the emitter or the circumference thereof. These countermeasures can be performed at a low cost.

In the illustrated embodiment, the LD array member 22 includes three or more emitters 26. These emitters 26 are disposed in the parallel arrangement in the main area 36 of the laser structure crystal 30 and generally at a regular pitch. The LD array member 22 also includes a plurality of second inactive areas 34 provided between every emitter 26 arranged side-by-side. These second inactive areas 34 have dimensions approximately identical to each other. Further, the LD array member 22 includes a pair of first inactive areas 32 disposed at opposite outsides of the main area 36, wherein each of the first inactive areas 32 has a dimension larger than each of the plural second inactive areas 34, as seen in the width direction (i.e., the direction transverse to the three or more stripe-shaped emitters 26). According to the above structure, Joule heat generated in the respective emitters 26 is balanced in the LD array member 22 and thus the temperature rise in the respective emitters 26 is generally equalized, so that there is little probability that any of the emitters is quickly deteriorated due to a large temperature rise, and thus it is possible to improve the quality and reliability of the LD array member 22 in its entirety.

In Fig. 1A, the laser structure crystal 30 is provided on the surface (or the upper surface) thereof with a positive or negative electrode surface 40 having an electrode pattern for injecting an electric current to the emitters 26, and the substrate crystal 28 is provided on the surface (or the lower surface) thereof, opposite to the surface 40, with an electrode surface 42 having a polarity opposite to the electrode surface 40 of the laser structure crystal 30. For example, in the case of the AlGaAs-type laser structure crystal 30, the positive electrode surface 40 is formed in the surface of the laser structure crystal 30, while the negative electrode surface 42 is formed in the surface of the substrate crystal 28.

Also, the LD array member 22 has a first facet 44 formed of a cleavage plane, in which laser beam emitting ends of the plural emitters 26 are disposed, and a second facet 46 formed of a cleavage plane opposite to the first facet 44, at least one of the first and second facets 44, 46 being covered by a coating material 48. In the illustrated embodiment, an insulating optical film is applied or vapor-deposited as the coating material 48 to each of the first and second facets 44, 46, for the purpose of protection from, e.g., oxidation and of control of a reflectance. In this case, the first facet 44 at the laser beam emitting side is applied or vapor-deposited with a low reflectance optical film, and the opposite second facet 46 is applied or vapor-deposited with a high reflectance optical film.

The LD array member 22 further has a pair of lateral outer surfaces 50 respectively intersecting each of the first and second facets 44, 46, at least one of the lateral surfaces 50 being covered at least partially by the coating material 48. For example, at a time when the coating material 48 is applied or vapor-deposited to the emitting-side first facet 44 and the opposite second facet 46 as described above, it is also possible to thinly apply or vapor-deposit the coating material 48 to both lateral outer surfaces 50. Thereby, even if a solder used as fixing means adheres to the lateral outer surfaces 50 of the LD array member at an instant when, e.g., the LD array member 22 is mounted to the cooling member 24 such as a heat sink, it is possible to prevent the p-n junction in the laser structure crystal 30 from being subjected to a short-circuit due to the solder. In this regard, although a production cost may occur, a step for applying or vapor-depositing the coating material solely to the lateral outer surfaces 50 may be introduced, so as to more effectively prevent a short-circuit from occurring in the lateral outer surfaces 50 of the LD array member 22.

As shown in Fig. 1B, the LD array member 22 is mounted to the cooling member 24 with the laser structure crystal 30 being closer to the cooling member 24, to ensure the efficient radiation of heat generated in the emitters 26. The mounting of the LD array member 22 is carried out by, e.g., fixing the electrode surface 40 of the laser structure crystal 30 to a metallic surface of the cooling member 24 by using a solder. If the lateral outer surfaces 50 of the LD array member 22 are exposed when the LD array member 22 is soldered in this way, the p-n junction in the laser structure crystal 30 may be subjected to a short-circuit due to the adhesion of the solder. However, in the illustrated embodiment, such a short-circuit is prevented by covering the lateral outer surfaces 50 of the LD array member 22 with the coating material 48 as described above.

The LD array member 22 is mounted to the cooling member 24 without cutting out portions 52 including the first inactive areas 32 at opposite ends, in which the scribe lines 38 are formed, from the main area 36 provided with the plural emitters 26. Then, an electro-conductive member such as a metallic sheet 56, insulated from the cooling member 24 by an insulating member such as an insulating plate 54 of a double-coated adhesive type, is fixed to the electrode surface 42 of the substrate crystal 28 in an electro-conductive manner by a soldering or others, so as to make possible for an electric current to be injected or supplied to the plural emitters 26 in the LD array member 22. In this manner, a high-performance semiconductor laser device 20 can be manufactured, at a low production cost, and provided with the highly reliable LD array member 22 free from the leakage current or the short-circuit. In this regard, the metallic sheet 56 may be provided with stress mitigating means, such as slits, for reducing a stress applied to the LD array member 22 due to the difference in coefficient of thermal expansion between the metallic sheet 56 and the LD array member 22.

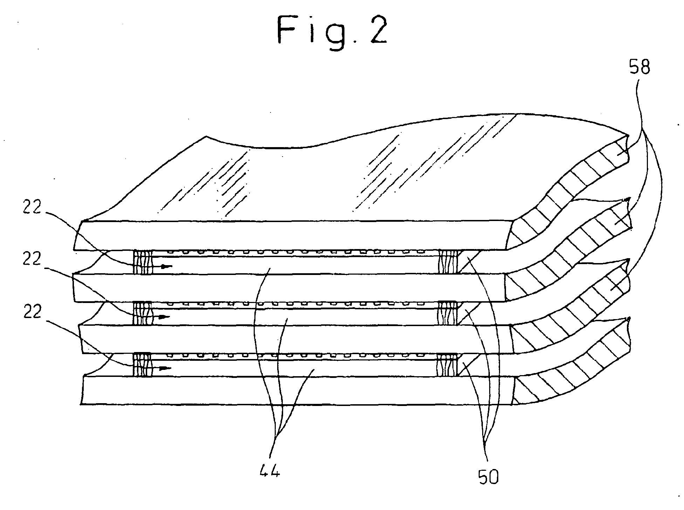

One exemplary process for applying or vapor-depositing the coating material 48 (Fig. 1A) to the lateral outer surfaces 50 of the LD array member 22, in the semiconductor laser device 20 according to the above-described first embodiment, will be described with reference to Fig. 2. When the coating material 48 is applied or vapor-deposited to the first facet 44 at the laser-beam emitting side of the LD array member 22, a plurality of LD array members 22 are stacked together, in a state where the positive and negative electrode surfaces 40, 42 of each LD array member 22 are held between and in contact with a pair of spacers 58. In this arrangement, the electrode surfaces 40, 42 of the LD array member 22 are concealed by the spacers 58, and thereby an insulating film of the coating material 48 is inhibited from being formed thereon. On the other hand, when the lateral outer surfaces 50 of the LD array member 22 are kept in an exposed state between the spacers 58, the coating material 48 is allowed to enter between the spacers 58 and to be thinly applied or vapor-deposited to the lateral outer surfaces 50. In this condition, when the coating material 48 is also applied or vapor-deposited to the second facet 46 of LD array member 22 in a similar way, the coating material 48 is additionally applied or vapor-deposited to the lateral outer surfaces 50. In this regard, a jig (not shown) carrying the LD array members 22 and the spacers 58 thereon may be rotated or moved during the applying or vapor depositing step, so as to make the lateral outer surfaces 50 oppositely face to a supply (not shown) of the coating material 48, in order to further increase the thickness of the coating material 48 on the lateral outer surfaces 50.

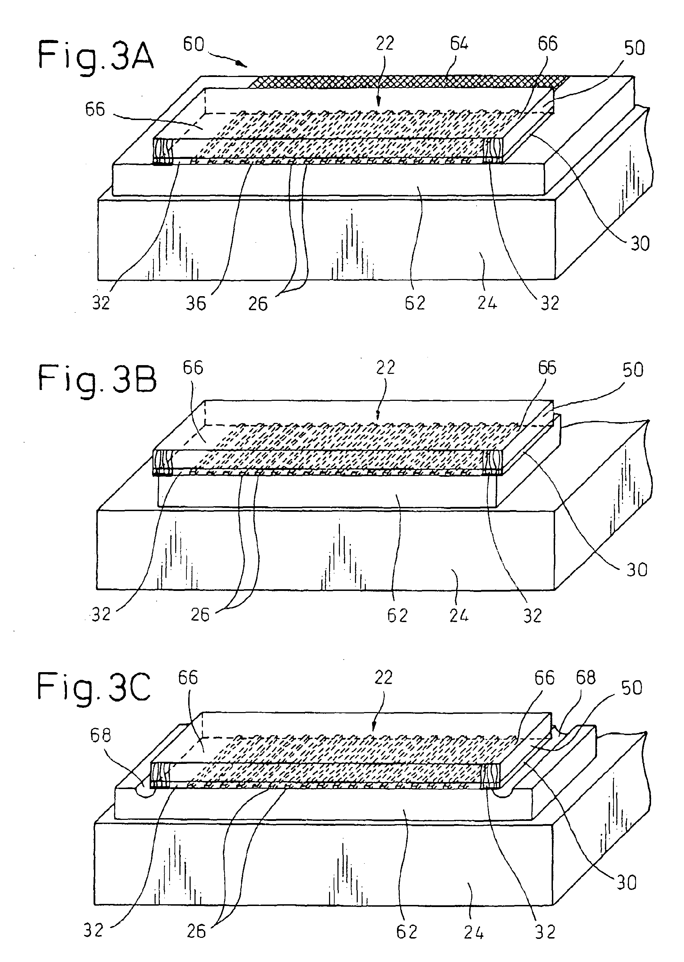

Figs. 3A to 3C illustrate a semiconductor laser device 60 according to a second embodiment of the present invention. The semiconductor laser device 60 has a structure substantially identical to the semiconductor laser device 20 of the first embodiment, except that a spacer (so called a die spacer) 62 is interposed between the LD array member 22 and the cooling member 24. Therefore, the corresponding components are denoted by common reference numerals and the detailed descriptions thereof are not repeated.

As shown in Fig. 3A, in the semiconductor laser device 60, the LD array member 22 is mounted to the cooling member 24, such as a heat sink or a cooling unit, through the die spacer 62. The LD array member 22 is mounted in such a manner that the main area 36 of the laser structure crystal 30 is mainly fixed by a solder to the die spacer 62, and the first inactive areas 32 at the opposite ends are disposed on the die space 62 to partially extend outward from a soldering surface 64 schematically or typically shown by a cross-hatching pattern. Alternatively, as shown in Fig. 3B, as a modification, the LD array member 22 may be soldered to the die spacer 62 in such a manner that the first inactive areas 32 at the opposite ends of the laser structure crystal 30 partially extend outward from the die spacer 62.

When opposite end areas 66 of the LD array member 22 are disposed to extend outward from the soldering surface 64 of the die spacer 62 (or from the die spacer 62 itself) as described above, the solder is hardly adhered to the lateral outer surfaces 50 of the LD array member 22, so that it is possible to further effectively prevent the p-n junction in the laser structure crystal 30 from being subjected to the short-circuit, and thus to improve the reliability and yield of the LD array member 22. In this arrangement, although it may be difficult to cool the end areas 66 of the LD array member 22, which are not soldered to the die spacer 62, the areas 66 correspond to the first inactive areas 32 of the laser structure crystal 30 provided with no emitter 26 and thus generate less heat, so that there is no problem from the viewpoint of performance or reliability. In other words, the provision of the relatively wider first inactive areas 32 at opposite ends of the LD array member 22 makes it possible to dispose the opposite end areas 66 of the LD array member 22 to extend outward from the die spacer 62 or the soldering surface 64 thereof, as shown in Figs. 3A and 3B, and thus solve the problem in the short-circuit of the p-n junction in the lateral outer surfaces 50.

In the structure shown in Fig. 3B, the opposite end areas 66 of the LD array member 22 extend outward from the die spacer 62, so that the opposite end areas 66 of the LD array member 22 may be damaged during the handling of the semiconductor laser device 60. To solve this inconvenience, as shown in Fig. 3C, the die spacer 62 may be provided with grooves 68 at positions corresponding to the opposite end areas 66 of the LD array member 22. In the structure shown in Fig. 3C, the opposite end areas 66 including the lateral outer surfaces 50 of the LD array member 22, which may be subjected to the problem of the short-circuit in the p-n junction, are disposed to extend outward from the soldering surface of the die spacer 62. On the other hand, peripheral areas of the die spacer 62 exist at the further outside of the opposite end areas 66 of the LD array member 22 to guard the opposite end areas 66, so that it is possible to prevent the opposite end areas 66 from being damaged.

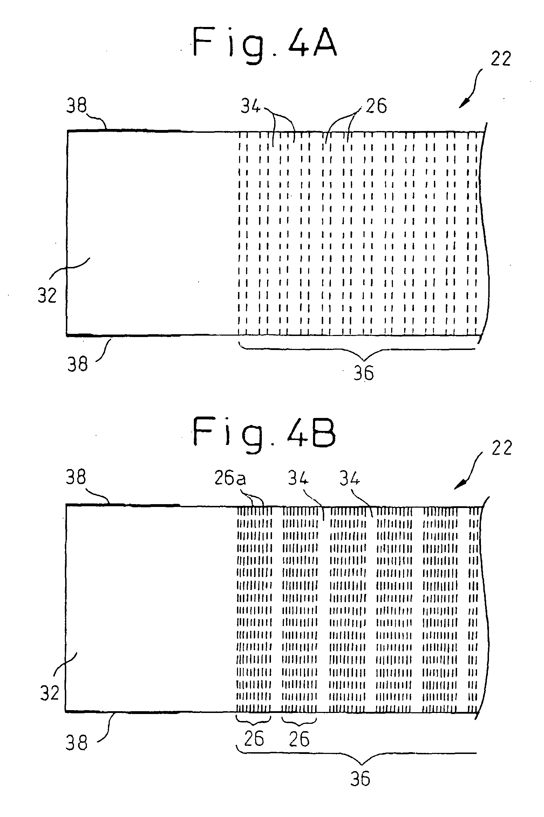

Fig. 4A is a partially enlarged plan view of the LD array member 22 according to the first and second embodiments, as shown from the side of the laser structure crystal 30, and illustrates a shape of a stripe element constituting the emitter 26 through which an electric current passes. As shown in Fig. 4A, the individual emitter 26 is constructed by a single stripe element having a relatively large width (or a dimension in a transverse direction). In this structure, it is possible to increase or decrease the number of emitters 26 by adjusting a width of the stripe. Such a single stripe structure is suitable for a high-power semiconductor laser device. However, if the width of the stripe increases, the distribution of light power (or the distribution of light intensity) in the emitter 26 is liable to be uneven in a width direction of the latter. Consequently, even if the stripe width increases, the light power of the LD array member 22 does not always increase in proportion thereto. Also, if the light intensity becomes high at a certain part of the emitter 26 due to the unbalance state of the distribution of light power in the width direction of the emitter 26, the deterioration of that part may be accelerated, and thus the reliability may be lowered. Accordingly, the number of stripes (i.e., the number of emitters 26) increases while maintaining a stripe width at a relatively thinner level, i.e., at least 10 µm (e.g., 10 to 50 µm), whereby it is possible to obtain a high power without reducing a total width of the stripes (= the stripe width x the number of stripes).

On the other hand, as shown in Fig. 4B, the respective emitter 26 may be constructed with the stripe aggregate including a plurality of stripe elements 26a, each having a relatively small width (or a dimension in a transverse direction) and disposed in a parallel arrangement. For example, each emitter 26 can be formed from a stripe aggregate in which a plurality of stripe elements 26a, each having a width of at most 5 µm, are arranged parallel to each other at a regular pitch of at most 5 µm. According to this structure, even if a total width of each emitter 26 increases, the uneven distribution of light power of the emitter 26 in the width direction of the latter hardly occurs, which makes it possible to realize a high power and a high reliability.

As is apparent from Figs. 4A and 4B, if the plural emitters 26 are dispersedly arranged parallel to each other in the LD array member 22, a width of the second inactive area 34 between the adjacent emitters inevitably becomes narrow. Then, the first inactive area 32 having a relatively wide width is provided outside of the main area 36 of the LD array member 22, and the scribe lines 38 for cutting the wafer in a cleaving manner to provide the LD array member 22 are formed in the first inactive area 32, so that it is possible to prevent the emitters 26 from being subjected to a damage due to the scribe lines 38. As a result, it is possible to employ an emitter structure capable of realizing a high reliability and a high power, as shown in Figs. 4A and 4B.

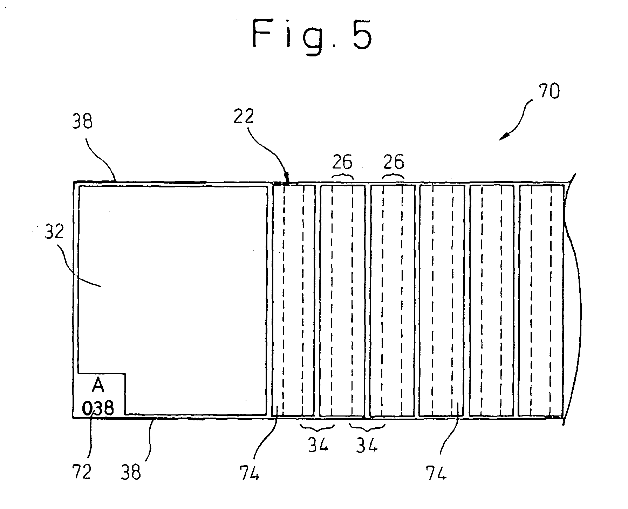

Fig. 5 illustrates a LD array member of a semiconductor laser device 70 according to a third embodiment of the present invention. The semiconductor laser device 70 has a structure substantially identical to the semiconductor laser device 20 in the first embodiment, except that an identification mark 72 is provided in the LD array member 22. Accordingly, the corresponding components are denoted by common reference numerals and the detailed descriptions thereof are not repeated.

As shown in Fig. 5, in the semiconductor laser device 70, the LD array member 22 includes the identification mark 72 formed on a surface portion corresponding to the first inactive area 32. The identification mark 72 includes a symbol or number for indentifying that the LD array member 22 is obtained from what portion of a wafer. For example, the identification mark 72 may be formed simultaneously in a step for forming an electrode surface (exemplary shown by electrode patterns 74) on the LD array member 22, which can restrict the increase in production cost. In this regard, it is preferred that the identification mark 72 is formed on the electrode surface 42 (Fig. 1B) of the substrate crystal 28, so that the identification mark 72 is readable even after the LD array member 22 is mounted on the cooling member 24. Also, the identification mark 72 is formed in the first inactive area 32 to which the electric current is not supplied, so that, if the metallic sheet 56 for electric current supply (Fig. 1B) is shaped so as not to cover the first inactive area 32, the identification mark 72 is readable even after the metallic sheet 56 is arranged for a electric wiring.

The identification mark 72 may be provided for each of the pair of first inactive areas 32 of the LD array member 22, in consideration of an occasion wherein the mark becomes difficult to be read due to a degradation of the pattern of the mark. For example, the identification mark 72 may include an identification number of the previously divided wafer cut to have a width identical to the width of the LD array member 22, and an identification number (or order) of the LD array member 22 in the divided wafer. According to this constitution, it is possible to determine that which part of the wafer results in the individual LD array member 22, and to distinguish the plural LD array members 22 from each other. Consequently, it is made possible to know the manufacturing condition of the respective LD array member 22 and confirm the distribution of characteristics in the wafer, whereby the quality control and/or the analysis of the individual LD array member 22 can be more precisely performed.

As is apparent from the above description, according to the present invention, it is possible to solve the problems in that the emitter of the LD array member is damaged due to the scribe line so as to increase the leakage current and deteriorate the characteristic, as well as to eliminate the step for cutting out the portion in which the scribe line is formed, whereby the reliability and performance of the semiconductor laser device using the LD array member are improved and the manufacturing cost is reduced.

While the invention has been described with reference to specific preferred embodiments, it will be understood by those skilled in the art that various changes and modifications may be made thereto without departing from the spirit and scope of the following claims.

## Claims

1. A semiconductor laser device (20; 60; 70) comprising an LD array member (22) having a monolithic linear-array configuration and provided with a plurality of emitters (26), respectively emitting a laser beam, in a parallel arrangement in a single semiconductor crystal (28, 30); **characterized in that**:
said LD array member (22) includes a main area (36) in which said emitters (26) are disposed in said parallel arrangement, a first inactive area (32) formed outside of said main area (26), and a second inactive area (34) formed between said emitters (26) disposed side-by-side in said main area (36); and that
said first inactive area (32) has a dimension larger than said second inactive area (34), as seen in a direction transverse to said plurality of emitters (26).

2. A semiconductor laser device as set forth in claim 1, wherein said LD array member (22) includes three or more emitters (26) disposed in said parallel arrangement at a regular pitch.

3. A semiconductor laser device as set forth in claim 1 or 2, wherein said LD array member (22) includes a plurality of second inactive areas (34) having dimensions identical to each other.

4. A semiconductor laser device as set forth in any one of claims 1 to 3, wherein said LD array member (22) includes three or more emitters (26), a pair of first inactive areas (32) disposed at opposite outsides of said main area (36) and a plurality of second inactive areas (34); each of said pair of first inactive areas (32) having a dimension larger than each of said plurality of second inactive areas (34), as seen in a direction transverse to said three or more emitters (26).

5. A semiconductor laser device as set forth in any one of claims 1 to 4, wherein said LD array member (22) includes a first facet (44), in which emitting ends of said emitters (26) are disposed, and a second facet (46) opposite to said first facet (44); at least one of said first facet (44) and said second facet (46) being covered by a coating material (48).

6. A semiconductor laser device as set forth in claim 5, wherein said LD array member (22) includes a pair of lateral faces (50) respectively intersecting each of said first and second facets (44, 46); at least one of said lateral faces (50) being covered at least partially by a coating material (48).

7. A semiconductor laser device as set forth in any one of claims 1 to 6, further comprising a cooling member (24) to which said LD array member (22) is mounted.

8. A semiconductor laser device as set forth in claim 7, further comprising a spacer (62) interposed between said LD array member (22) and said cooling member (24).

9. A semiconductor laser device as set forth in any one of claims 1 to 8, wherein each of said plurality of emitters (26) is a single stripe element having a dimension of at least 10 µm in a transverse direction.

10. A semiconductor laser device as set forth in any one of claims 1 to 8, wherein each of said plurality of emitters (26) is a stripe aggregate including a plurality of stripe elements (26a), each having a dimension of at most 5 µm in a transverse direction, disposed in a parallel arrangement at a regular pitch of at most 5 µm.

11. A semiconductor laser device as set forth in any one of claims 1 to 10, wherein said LD array member (22) includes an identification mark (72) formed on a surface portion corresponding to said first inactive area (32).
